# EUROPEAN PATENT APPLICATION

(11) **EP 4 459 869 A1**
(43) Date of publication of application: **06.11.2024**
(21) Application number: 24172359.2
(22) Date of filing: 25.04.2024
(51) Int. Cl.: H03K 19/003, G06F 30/392

(54) **INTEGRATED CIRCUIT, SEMICONDUCTOR DEVICE, AND METHOD OF DESIGNING LAYOUT OF SEMICONDUCTOR DEVICE**

(30) Priority: 03.05.2023 KR 20230057993; 17.07.2023 KR 20230092731
(71) Applicant: Samsung Electronics Co., Ltd., Suwon-si, Gyeonggi-do 16677 (KR)
(72) Inventor: PARK, Chanhee, 16677 Suwon-si (KR); KIM, Byung-su, 16677 Suwon-si (KR); HWANG, Hyunchul, 16677 Suwon-si (KR)
(74) Representative: Marks & Clerk LLP

(57) **Abstract**

A semiconductor device includes a plurality of semiconductor dies spaced from each other in a vertical direction and an inter-die interface that electrically connects the plurality of semiconductor dies. The plurality of semiconductor dies includes a transceiver circuit that transmits and receives a clock signal and a data signal through the inter-die interface, and a delay control circuit located on a signal transmission path of one signal among the clock signal and the data signal for delaying the one signal. At least one semiconductor die among the plurality of semiconductor dies is a logic die. The hybrid semiconductor device according to an embodiment of the present disclosure may reduce skew between dies.

## Description

### 1. Technical Field

Embodiments of the present disclosure described herein are directed to a semiconductor technology, and are more particularly directed to a semiconductor device and a method of designing a layout of the semiconductor device.

### 2. Discussion of Related Art

Various semiconductor package technologies are emerging due to the demand for high-capacity, thin, and small semiconductor devices. A semiconductor package is manufactured by implementing an integrated circuit chip in a form suitable for use in electronic products. The semiconductor package is generally manufactured by mounting a semiconductor chip on a printed circuit board (PCB) and electrically connecting the semiconductor chip and the PCB by using bonding wires or bumps. A technology for stacking and connecting each chip (die) is used for increasing the density of semiconductor devices. However, this stacking may lead to a clock skew or a data skew. Clock skew refers to the difference in arrival time of a clock signal at different components within a circuit, which may lead to errors in time-sensitive operations. Data skew refers to the difference in arrival time of data bits, which may lead to errors in data transmission and reception.

### SUMMARY

Embodiments of the present disclosure provide an integrated circuit having a reduced skew of transmission signals between stacked dies, a semiconductor device having the reduced skew of transmission signals between stacked dies, and a layout design method of the semiconductor device.

According to an embodiment, a semiconductor device includes a plurality of semiconductor dies spaced from each other in a vertical direction and an inter-die interface that electrically connects the plurality of semiconductor dies. The plurality of semiconductor dies includes a transceiver circuit that transmits and receives a clock signal and a data signal through the inter-die interface, and a delay control circuit located on a signal transmission path of one signal among the clock signal and the data signal for delaying the one signal. At least one semiconductor die among the plurality of semiconductor dies is a logic die.

According to an embodiment, an integrated circuit includes an inter-die interface that provides an electrical connection between a plurality of semiconductor dies spaced apart from each other in a vertical direction, a transceiver circuit that transmits and receives a clock signal and a data signal through the inter-die interface, and a delay control circuit located on a signal transmission path of one signal among the clock signal and the data signal for delaying the one signal. At least one semiconductor die among the plurality of semiconductor dies is a logic die.

According to an embodiment, a method of designing a layout of a semiconductor device includes: identifying at least one hard macro among a plurality of hard macros and at least one standard cell based on input data defining an integrated circuit; performing floorplanning on the identified at least one hard macro based on the input data; performing placing of the identified at least one standard cell based on a result of the floorplanning; performing routing based on a result of the floorplanning and a result of the placing, and generating output data defining the integrated circuit based on the results of the floorplanning, the placing, and the routing. The at least one hard macro includes a design for an inter-die interface circuit that provides an electrical connection between a plurality of semiconductor dies spaced apart from each other in a vertical direction, a design for a transceiver circuit that transmits and receives a clock signal and a data signal through the inter-die interface circuit, and a design for a delay control circuit located on a signal transmission path of one signal among the clock signal and the data signal for delaying the one signal.

The delay control circuit may delay an internal clock signal which is used to delay the data signal.

At least some of the above and other features of the disclosure are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram illustrating a semiconductor device, according to an embodiment of the present disclosure.
FIG. 2 is a diagram showing an inter-die interface of a semiconductor device according to an embodiment of FIG. 1.
FIG. 3 is a cross-sectional view illustrating an inter-die interface of a semiconductor device according to an embodiment of FIG. 1.
FIG. 4 is a block diagram of a semiconductor device, according to an embodiment of the present disclosure.
FIG. 5 is a block diagram of a data transmission circuit and a delay control circuit of a semiconductor device according to an embodiment of FIG. 4.
FIG. 6 is a circuit diagram of an inter-die interface driving circuit of a semiconductor device according to an embodiment of FIG. 4.
FIG. 7 is a circuit diagram of a delay control input circuit of a semiconductor device according to an embodiment of FIG. 4.
FIG. 8 is a circuit diagram of a delay control element circuit of a semiconductor device according to an embodiment of FIG. 4.
FIG. 9 is a block diagram of a semiconductor device, according to an embodiment of the present disclosure.
FIG. 10 is a block diagram of a semiconductor device, according to an embodiment of the present disclosure.
FIG. 11 is a block diagram of a semiconductor device, according to an embodiment of the present disclosure.
FIG. 12 is a block diagram of a semiconductor device, according to an embodiment of the present disclosure.
FIGS. 13A and 13B are cross-sectional views showing embodiments of an inter-die interface, according to an embodiment of the present disclosure.
FIG. 14 is a block diagram of a semiconductor designing device, according to an embodiment of the present disclosure.
FIG. 15 is a flowchart showing an example of a layout designing method of a semiconductor designing device, according to an embodiment of the present disclosure.

### DETAILED DESCRIPTION

Hereinafter, embodiments of the present disclosure may be described in detail and clearly to such an extent that an ordinary one in the art easily implements the present disclosure.

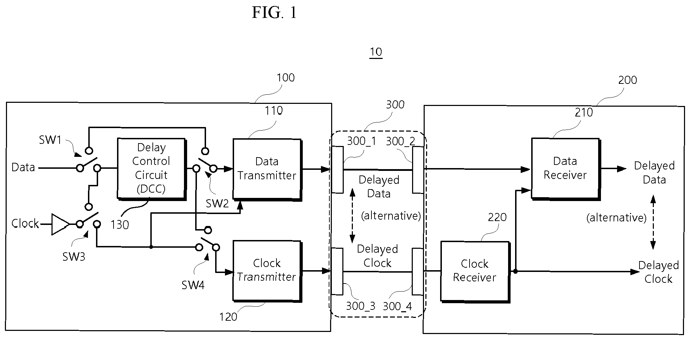

FIG. 1 is a block diagram conceptually illustrating a semiconductor device, according to an embodiment of the present disclosure. Referring to FIG. 1, a semiconductor device 10 includes a first die 100 and a second die 200. The first die 100 includes transmission/reception circuits 110 and 120, and the second die 200 includes transmission/reception circuits 210 and 220. The first die 100 may include a delay control circuit 130. Transmission circuits 110 and 120, and reception circuits 210, and 220 may be a transceiver circuit. For example, the transmission/reception circuits 110 and 120 may include a data transmitter 110 for transmitting data and a clock transmitter 120 for transmitting a clock signal. For example, the transmission/reception circuits 210, and 220 may include a data receiver 210 for receiving data and a clock receiver transmitter 220 for receiving a clock signal.

Referring to FIG. 1, the first die 100 and the second die 200 are positioned to be spaced apart from each other in a vertical direction and may be electrically connected to transmit and receive signals to each other. In this specification, the vertical direction may be a direction perpendicular to a substrate of a die. Embodiments of the present disclosure show two stacked dies, but the present disclosure is not limited to the two stacked dies. That is, two or more dies may be stacked. The die may also be referred to as a "chip".

The same type of integrated circuits may be formed as the first die 100 and the second die 200, or different types of integrated circuits may be formed as the first die 100 and the second die 200. For example, the first die 100 may be a logic die, and the second die 200 may be a memory die. Alternatively, both the first die 100 and the second die 200 may be logic dies or both the first die 100 and the second die 200 may be memory dies.

In an embodiment, at least one of the first die 100 or the second die 200 may be a logic die. For example, the first die 100 may be a die, which is implemented as a central processing unit (CPU) chip, a graphic processing unit (GPU) chip, or an application processor (AP) chip, or in which a functional part thereof is implemented. In this specification, the logic die refers to a semiconductor chip that performs logical operations. For example, the logic die may include a logic cell. The logic cell may be variously implemented by including a plurality of circuit elements such as transistors and resistors. The logic cell may be implemented as various logic gates, operation circuits, multiplexers, flip-flops, latches, and the like. The logic cells may consist of standard cells that perform specific logical functions such as a counter, a buffer, and the like.

In another embodiment, at least one of the first die 100 or the second die 200 may be a memory die. For example, the second die 200 may be a memory die. For example, the second die 200 may be a dynamic random access memory (DRAM) chip, a static random access memory (SRAM) chip, a flash memory chip, and a phase-change random access memory (PRAM) chip, a magnetic random access memory (MRAM) chip, or a resistive random access memory (RRAM) chip. The memory die may include a memory cell array, in which memory cells are placed, and peripheral circuits that control the memory cell array.

The first die 100 and the second die 200 may be connected to transmit and receive signals with each other. For example, the first die 100 and the second die 200 may transmit and receive clock signals or data signals through an inter-die interface 300 (e.g., an interface circuit). When one die transmits a signal through the inter-die interface 300, the other die may receive the signal transmitted through the inter-die interface 300.

The first die 100 and the second die 200 may include the inter-die interface 300 for exchanging signals with each other. The inter-die interface 300 may include inter-die contacts 300_1, 300_2, 300_3, and 300_4 that are electrically connected to transmit signals. For example, the inter-die interface 300 may include the inter-die contacts 300_1, 300_2, 300_3, and 300_4 used for micro-bump bonding, thermal compression bonding (TCB), or hybrid copper bonding. The inter-die contacts 300_1, 300_2, 300_3, and 300_4 may be micro-bumps, copper pillars, metal pads, and the like. According to an embodiment, the inter-die interface 300 includes intermediate electrodes located inside a first die 100 and a second die 200 to provide electrical signals to the inter-die contacts 300_1, 300_2, 300_3, and 300_4. The intermediate electrodes may be located in an internal metal wiring layer of the first die 100 and the second die 200. The inter-die interface 300 may include a through-silicon-via (TSV) that penetrates at least part of an inside of a substrate in a die bonding method.

The first die 100 and the second die 200 may include transmission/reception circuits 110, 120, 210, and 220 for transmitting and receiving clock signals or data signals through the inter-die interface 300. For example, FIG. 1 shows that the first die 100 includes the transmission circuits 110 and 120, and the second die 200 includes the reception circuits 210 and 220. According to an embodiment, the first die 100 may additionally include a reception circuit, and the second die 200 may additionally include a transmission circuit.

Each of the dies 100 and 200 of the semiconductor device 10 may include the transmission/reception circuit 110 and 210 for a data signal and the transmission/reception circuit 120 and 220 for a clock signal. The transmission/reception circuits 110 and 210 for the data signal and the transmission/reception circuits 120 and 220 of the clock signal may be the same as or different from each other. For example, the data transmission circuit 110 and the clock transmission circuit 120 of the first die 100 may be implemented by the same circuit or by separate circuits.

One die of the semiconductor device 10 according to an embodiment of the present disclosure includes the delay control circuit 130 that delays a clock signal or a data signal. FIG. 1 shows that the first die 100 includes the delay control circuit 130. However, the second die 200 may include the delay control circuit. Alternatively, both the first die 100 and the second die 200 may include a delay control circuit.

Either the clock signal or the data signal may be delayed by the delay control circuit 130. The delay control circuit 130 may be positioned in a transmission path of a clock signal or a transmission path of a data signal, and may alternatively delay one of the clock signal or the data signal.

For example, referring to FIG. 1, a first switch SW1 may select a path through which the data signal is input to the delay control circuit 130. A second switch SW2 may select a path where the output of the delay control circuit 130 is input to the data transmission circuit 110. In an embodiment, a third switch SW3 and a fourth switch SW4 may select a path, through which the clock signal is directly input to the clock transmission circuit 120 without going through the delay control circuit 130. Accordingly, the data signal of the first die 100 may be delayed by the delay control circuit 130, and the clock signal may not be delayed. The delayed data signal and the non-delayed clock signal may be provided to the data transmission circuit 110. The delayed data signal and the non-delayed clock signal may be transmitted to the second die 200 through the inter-die interface 300.

FIG. 1 shows an embodiment in which a clock signal or a data signal is selectively provided to one of the delay control circuits 130 by the switches SW1, SW2, SW3, and SW4. According to an embodiment, the delay control circuit 130 is placed only in one of the transmission path of a clock signal or the transmission path of a data signal.

Accordingly, the semiconductor device 10 according to an embodiment of the present disclosure may delay a data signal or a clock signal. On the basis of the degree of skew of the data signal or clock signal between stacked dies, the amount of delay may be determined by a separate circuit or may be input from an external source. Accordingly, the skew of the data signal or the clock signal between stacked dies may be reduced. As a result, stable transmission of data signals and clock signals between stacked dies is possible, and stable operation of a semiconductor device may be guaranteed.

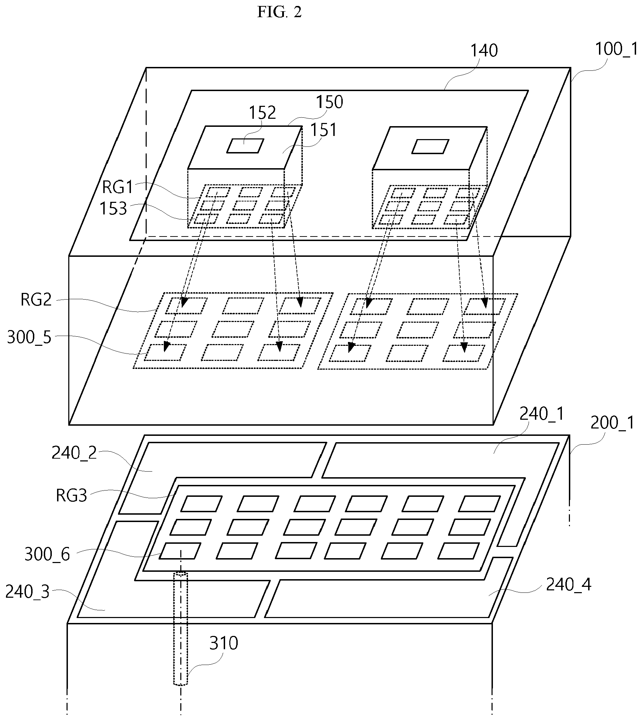

FIG. 2 is a diagram illustrating an inter-die interface between stacked semiconductor dies 100_1 and 200_1 of the semiconductor device 10 according to an embodiment of FIG. 1. The semiconductor die 100_1 may be used to implement the first die 100 and the semiconductor die 200_1 may be used to implement the second die 200.

At least one semiconductor die among the semiconductor dies 100_1 and 200_1 may include at least one functional block.

Referring to FIG. 2, it is shown that the first die 100_1 includes one functional block region 140, and the second die 200_1 includes a plurality of functional block regions 240_1, 240_2, 240_3, and 240_4. According to an embodiment, a plurality of functional blocks may be placed in each functional block region. Alternatively, one functional block may be placed in any functional block region.

The functional block may be a control circuit (controller), an arithmetic logic unit (ALU), a memory, or the like. Alternatively, a functional block may be a chip designed to perform a specific function. For example, the functional block may be one of a central processing unit (CPU), input/output interface (I/O interface) unit, an artificial intelligence (AI) operation processing unit (e.g., TPU), a graphics processing unit (GPU), and a signal processor, or a media processing unit (MPU) chip.

A semiconductor device according to an embodiment of the present disclosure includes a logic circuit for signal transmission between stacked dies, inside the functional block. That is, at least one of the transmission/reception circuit and the delay control circuit described with reference to FIG. 1 may be placed inside the functional block. When viewed in a direction perpendicular to a plane of a substrate, at least one of the transmission/reception circuit and the delay control circuit may be placed to be surrounded by a functional block.

Referring to FIG. 2, an interface module 150 may be disposed inside the functional block 140. The functional block 140 may be formed in an active region of a back side of the first die 100_1. The interface module 150 may include interface logic 151 and an interface contact 152. The interface logic 151 may include at least one of a transmission/reception circuit and a delay control circuit. The active region may be formed to have a specific depth in an inner direction of the substrate. The interface logic 151 may be positioned around the interface contact 152. The functional block 140 may be arranged to surround the interface logic 151 around the interface logic 151.

The interface contact 152 may provide an electrical connection between an inter-die contact 300_5 and the interface logic 151. Intermediate electrodes 153 may be located in a signal path between the interface contact 152 and the inter-die contacts 300_5. The intermediate electrodes 153 may be located inside of the first die 100_1. The intermediate electrodes 153 may be arranged in a vertical direction. The inter-die contacts 300_5 may be formed on a front side of the first die 100_1. The intermediate electrodes 153 correspond to the inter-die contacts 300_5, respectively.

The inter-die interface of an embodiment described with reference to FIG. 2 may include the inter-die contact 300_5 for bonding between a plurality of dies, the intermediate electrode 153 that provides an electrical signal to the inter-die contact 300_5, and the interface contact 152.

The interface contact 152 may provide the intermediate electrode 153 with output signals from a transmission/reception circuit and a delay control circuit.

The intermediate electrodes 153 may be formed in a specific region RG1 inside the first die 100_1. The inter-die contacts 300_5 may be formed in a specific region RG2 on a front side of the first die 100_1. In an embodiment, an area size of the region RG2 where the inter-die contacts 300_5 are formed is larger than an area size of the region RG1 where the intermediate electrodes 153 are formed. The area size may mean an area size of a cross section of a region parallel to the substrate.

The inter-die contacts 300_5 of the first die 100_1 are electrically connected to inter-die contacts 300_6 of the second die 200_1. Accordingly, the clock signal and the data signal, which are transmitted from the first die 100_1, may be transmitted to the second die 200_1 through the inter-die contacts 300_5 and the inter-die contacts 300_6. Alternatively, the clock signal and the data signal, which are transmitted from the second die 200_1, may be transmitted to the first die 100_1 through the inter-die contacts 300_5 and the inter-die contacts 300_6.

In an embodiment, the first die 100_1 is physically bonded to the second die 200_1 through the inter-die contacts 300_5 and the inter-die contacts 300_6. In an embodiment, the inter-die contacts 300_6 of the second die 200_1 are formed on a back side of the second die 200_1. The back side of the second die 200_1 may oppose the front side of the first die 100_1.

The inter-die contacts 300_6 of the second die 200_1 may be placed in a specific region RG3 on the back side of the second die 200_1. The functional blocks 240_1, 240_2, 240_3, and 240_4 of the second die 200_1 may be placed around the region RG3 where the inter-die contacts 300_6 are placed. For example, the functional blocks 240_1, 240_2, 240_3, and 240_4 may surround the region RG3.

The inter-die contacts 300_6 of the second die 200_1 may be electrically connected to a TSV 310 that penetrates at least part of a substrate in a direction perpendicular to the substrate of the second die 200_1. In this case, the region RG3 where the inter-die contacts 300_6 are placed may be a TSV region.

An area size of a substrate where elements are not placed may be reduced by placing a logic circuit for signal transmission between stacked dies inside the functional block in at least one die. In other words, overhead due to occupying a specific area size of a substrate may be reduced. In an embodiment, an area size of the region RG2 where inter-die contacts are placed is formed to be larger than an area size of the region RG1 where the intermediate electrodes 153 are formed or an area size of a region of the interface contact 152. Accordingly, stable bonding between dies may be guaranteed.

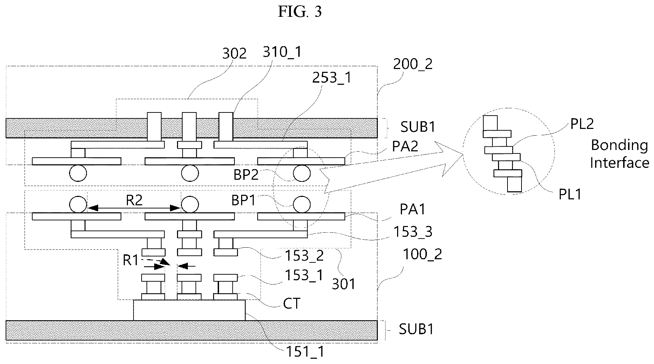

FIG. 3 is a cross-sectional view illustrating an inter-die interface between stacked semiconductor dies of the semiconductor device 10 according to an embodiment of FIG. 1.

Inter-die interfaces 301 and 302 of a semiconductor die 10 according to an embodiment of the present disclosure may include a structure that provides a path for electrical signals between stacked dies 100_2 and 200_2. The inter-die interfaces 301 and 302 may include structures that provide bonding between the dies 100_2 and 200_2. The die 100_2 may be used to implement die 100_1 and the die 200_2 may be used to implement die 200_1.

For example, the inter-die interface 301 of the first die 100_2 may include an interface contact CT, a plurality of intermediate electrodes 153_1, 153_2, and 153_3, a pad PA1, and a micro-bump BP1. The inter-die interface 302 of the second die 200_2 may include a micro-bump BP2, a pad PA2, at least one intermediate electrode 253_1, and a TSV 310_1.

The interface contact CT is electrically connected to the interface logic 151_1. The interface logic 151_1 may be formed in an active region of a substrate (e.g., SUB1). The interface logic 151_1 may include a data transmission circuit or a clock transmission circuit. The interface contact CT may be electrically connected to the data transmission circuit or clock transmission circuit of the first die 100_2. The interface contact CT provides the intermediate electrode 153_1 with a data signal or a clock signal. The data transmission circuit and the clock transmission circuit may be implemented as one circuit or as separate circuits.

Referring to FIG. 3, the interface contact CT may be connected to the interface logic 151_1 in an inner direction of the first die 100_2. According to an embodiment, when viewed from a direction perpendicular to the substrate, the interface contact CT may be connected to the interface logic 151_1 in any region around the interface logic 151_1.

There may be the plurality of interface contacts CT, and each of the plurality of interface contacts CT may be placed at an interval of a first pitch R1. For example, the interface contacts CT may be spaced apart from one another by a certain distance.

The output signal of the interface contact CT of the first die 100_2 is provided to the pad PA1 through the plurality of intermediate electrodes 153_1, 153_2, and 153_3. Some of the plurality of intermediate electrodes 153_1, 153_2, and 153_3 may be located at different depths inside the first die 100_2. For example, the first intermediate electrode 153_1 connected to the interface contact CT may be located to be closer to a substrate SUB1 than the second intermediate electrode 153_2. The second intermediate electrode 153_2 may be located closer to the substrate SUB1 than the third intermediate electrode 153_3 connected to the pad PA1. According to an embodiment, the first intermediate electrode 153_1 is connected to the third intermediate electrode 153_3 through vertical wiring without passing through the second intermediate electrode 153_2. The plurality of intermediate electrodes 153_1, 153_2, and 153_3 may be located in a metal wiring layer inside the first die 100_2.

When there are the plurality of interface contacts CT, the interface contacts CT may correspond to the plurality of micro-bumps BP1, respectively. In an embodiment, the plurality of micro-bumps BP1 are placed at an interval of a second pitch R2.

The second pitch R2 between the micro-bumps BP1 of the semiconductor die 10 according to an embodiment of the present disclosure is greater than the first pitch R1 between the interface contacts CT. Accordingly, stable bonding between dies may be guaranteed. Moreover, due to the small first pitch R1 between the interface contacts CT, the interface logic 151_1 may be placed inside a functional block. As a result, the area size of a region where elements are not placed on a substrate may be reduced.

When the first die 100_2 and the second die 200_2 are bonded to each other through micro-bump bonding or thermal compression bonding, the pad PA1 may be physically and electrically connected to the micro-bump BP1. The micro-bump BP1 of the first die 100_2 and the micro-bump BP2 of the second die 200_2 may be bonded to each other in a thermocompression process.

In an embodiment, when the first die 100_2 and the second die 200_2 are bonded to each other through hybrid copper bonding, a metal pad PL1 of the first die 100_2 and a metal pad PL2 of the second die 200_2 may be used for bonding. The metal pads PL1 and PL2 may be copper pillars.

The inter-die interfaces 301 and 302 of the semiconductor die 10 according to an embodiment of the present disclosure may be configured as a hard macro. A hard macro may be a pre-designed optimized block of functionality used in IC design. Unlike a soft macro, which may be written in a hardware description language, a hard macro may be implemented at the physical level using a layout tool. According to an embodiment, at least some circuits of the interface logic 151_1 are configured as one hard macro together with the inter-die interfaces 301 and 302. For example, at least one of the transmission/reception circuit and the delay control circuit may be configured as a hard macro together with the inter-die interfaces 301 and 302. For example, at least some circuits of the interface logic 151_1 and the inter-die interfaces 301 and 302 may be manufactured using a single hard macro. For example, at least one of the transmission/reception circuit, the delay control circuit, and the inter-die interfaces 301 and 302 may be manufactured using a single hard macro.

In this specification, the term macro may refer to a building block or a functional circuit element of logic that is capable of being used in a process of manufacturing an application specific integrated circuit (ASIC) or field programmable gate array (FPGA). In the hard macro, a wiring pattern is specified and internal routing is completed. Accordingly, it is impossible to change the hard macro. On the other hand, a soft macro has flexibility in physical implementation because a wiring pattern of the soft macro is not specified. However, the soft macro requires internal routing.

A large number of inter-die interfaces may be required to transmit signals between stacked dies. Accordingly, according to an embodiment of the present disclosure, the time and load for performing place and routing of the inter-die interface may be reduced by implementing an inter-die interface by using a hard macro. For example, components of a circuit may be placed and routing of wires to one or more of the components or between two or more of the components may be performed by referring to the hard macro.

According to an embodiment of the present disclosure, the transmission of at least one of a data signal or a clock signal transmitted through the hard macro of the inter-die interfaces 301 and 302 may be delayed during a specific time by a delay control circuit. For example, transmission of at least one of a data signal or a clock signal transmitted through a component referenced by the hard macro may be delayed during a specific time by a delay control circuit. The delay control circuit may be a part of the interface logic 151_1.

For example, when the hard macro of the inter-die interfaces 301 and 302, in which internal routing is completed, is used for bonding between dies, a data signal path inside the hard macro of the inter-die interfaces 301 and 302 is fixed. Accordingly, circuits inside the hard macro of the inter-die interfaces 301 and 302 may not perform engineering change order (ECO) at a register transfer level (RTL). Also, performing a clock tree synthesis (CTS) between three-dimensionally stacked dies may not be easy. Performing the CTS may include a process of inserting buffers or inverters along clock paths of an IC design to achieve minimal clock skew. However, due to various factors such as a process difference between stacked dies, skew between dies may occur.

Accordingly, when skew occurs between two dies bonded with the hard macro of the inter-die interfaces 301 and 302 in which internal routing is completed, the delay control circuit may delay the transmission of a clock signal or data signal during a specific time. As a result, skew between dies may be reduced. Moreover, even after fab-out of a semiconductor device, timing between dies may be easily adjusted by using the delay control signal. The fab-out may refer to outsourcing the fabrication of an IC to a specialized company called a foundry.

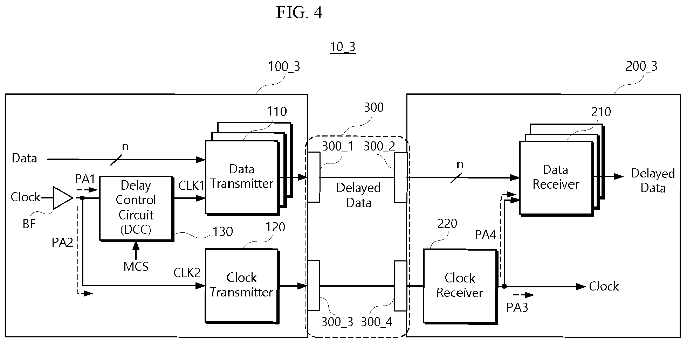

FIG. 4 is a block diagram of a semiconductor device, according to an embodiment of the present disclosure.

Referring to FIG. 4, a semiconductor device 10_3 includes a first die 100_3, a second die 200_3, and the inter-die interface 300. The first die 100_3 includes the data transmission circuit 110, the clock transmission circuit 120, and the delay control circuit 130. The second die 200_3 includes the data reception circuit 210 and the clock reception circuit 220. Detailed descriptions of parts identical or similar to those described above with reference to FIGS. 1 to 3 will be omitted to avoid redundancy. The first die 100_3 may be used to implement the first die 100 and the second die 200_3 may be used to implement the second die 200.

The delay control circuit 130 of the semiconductor device 10_3 according to an embodiment of the present disclosure is located on a first signal transmission path PA1. The first signal transmission path PA1 refers to a path where a clock signal Clock is input to the data transmission circuit 110 of the first die 100_3.

The clock signal Clock may be provided to the first signal transmission path PA1 and a second signal transmission path PA2 through a buffer BF (e.g., an operational amplifier). The clock signal Clock may be received from a functional block of the first die 100_3 or from an external input. A clock signal CLK2 passing through the second signal transmission path PA2 is provided to the clock transmission circuit 120. The clock transmission circuit 120 converts a voltage level of the clock signal CLK2 into a voltage level capable of being transmitted through the inter-die interface 300 to generate a converted signal and provides the converted signal to the inter-die interface 300. The clock signal CLK2 passing through the second signal transmission path PA2 is provided to the clock reception circuit 220 of the second die 200_3. Accordingly, a non-delayed clock signal is transmitted to the second die 200_3.

According to an embodiment of the present disclosure, the clock signal Clock passing through the first signal transmission path PA1 is provided to the delay control circuit (DCC) 130. The delay control circuit 130 provides the data transmission circuit 110 with a clock signal CLK1, which is obtained by delaying the received clock signal Clock during a specific time. The delay control circuit 130 may delay the received clock signal Clock during a specific time based on a delay control signal MCS.

The data signal Data output from the functional block of the first die 100_3 may be input to the data transmission circuit 110. The data signal Data input to the data transmission circuit 110 is output based on the delayed clock signal CLK1 received from the delay control circuit 130. The data transmission circuit 110 provides a data signal to the inter-die interface 300. As a result, a delayed data signal Delayed Data is transmitted to the second die 200_3.

Accordingly, when skew occurs between the two stacked dies 100_3 and 200_3, the skew may be reduced by providing the data transmission circuit 110 with the clock signal CLK1 delayed by the delay control circuit 130.

The first die 100_3 according to an embodiment of the present disclosure includes the plurality of data transmission circuits 110. The plurality of data transmission circuits 110 may be electrically connected to the plurality of inter-die interfaces 300, respectively. Each of the plurality of inter-die interfaces 300 may be composed of a hard macro. For example, each of the plurality of inter-die interfaces 300 may be manufactured using a separate hard macro.

In an embodiment, the delayed clock signal CLK1 output by the delay control circuit 130 is equally provided to each of the plurality of data transmission circuits 110. Accordingly, it is possible to equally delay all data signals transmitted by the plurality of data transmission circuits 110 only by setting a single delay control signal MCS.

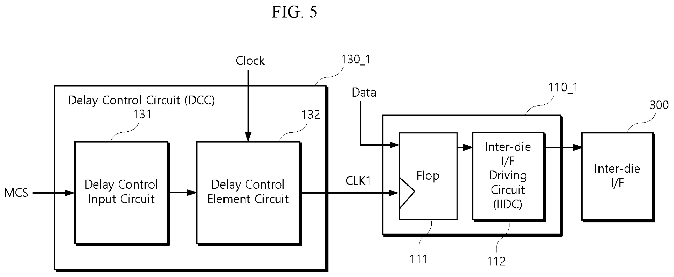

FIG. 5 is a block diagram of a data transmission circuit and a delay control circuit according to an embodiment of FIG. 4.

Referring to FIG. 5, a data transmission circuit 110_1 includes a flip-flop 111 and an inter-die interface driving circuit (IIDC) 112. The data transmission circuit 110_1 may be used to implement a data transmitter 110.

A delay control circuit 130_1 according to an embodiment of the present disclosure includes a delay control input circuit 131 and a delay control element circuit 132. The delay control circuit 130_1 may be used to implement the delay control circuit 130.

The delay control input circuit 131 receives the delay control signal MCS from the outside. The delay control signal MCS may include information related to the amount of delay of a signal to be delayed. According to embodiments, the delay control signal MCS may be the serialized delay control signal MCS or the parallelized delay control signal MCS. When the delay control input circuit 131 receives the serialized delay control signal MCS, the delay control input circuit 131 may parallelize the serialized delay control signal MCS and provide the parallelized delay control signal MCS to the delay control element circuit 132.

The delay control element circuit 132 delays a signal received during a time corresponding to a predetermined delay amount based on the delay control signal MCS to generate a delayed signal and then outputs the delayed signal. For example, when the received signal is the clock signal Clock, the delay control element circuit 132 may delay and output the clock signal Clock for a time corresponding to the predetermined delay amount. Alternatively, when the received signal is the data signal Data, the delay control element circuit 132 may delay and output the data signal Data for a time corresponding to the predetermined delay amount.

The flip-flop 111 of the data transmission circuit 110_1 may be a part of a circuit that processes a data signal to be transmitted through the inter-die interface 300. For example, the flip-flop 111 may be a part of various types of signal processing circuits, such as error verification of data signals, encoding of data signals, and the like. The flip-flop 111 may be a D-flip-flop.

The flip-flop 111 outputs the received data signal Data based on the delayed clock signal CLK2 provided by the delay control circuit 130_1. The flip-flop 111 provides the data signal Data to the inter-die interface driving circuit 112. The inter-die interface driving circuit 112 converts the received data signal into a voltage level capable of being transmitted through the inter-die interface 300 to generate a converted signal and provides the converted signal to the inter-die interface 300.

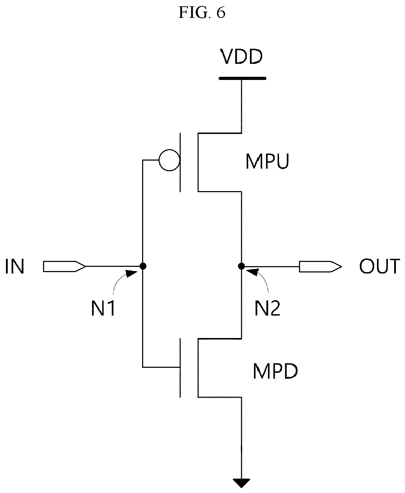

FIG. 6 is a circuit diagram of an inter-die interface driving circuit according to an embodiment of FIG. 5.

In an embodiment, the inter-die interface driving circuit 112 includes a pull-up transistor MPU and a pull-down transistor MPD. A source node of the pull-up transistor MPU is connected to a power supply voltage VDD. A drain node of the pull-up transistor MPU is connected to a drain node of the pull-down transistor MPD through an output terminal N2.

As a common gate, a gate node of each of the pull-up transistor MPU and the pull-down transistor MPD receives an input signal IN through an input terminal N1.

The inter-die interface driving circuit 112 converts and outputs a voltage level of the input signal IN into a voltage level of an output signal OUT capable of being transmitted through an inter-die interface based on the power supply voltage VDD.

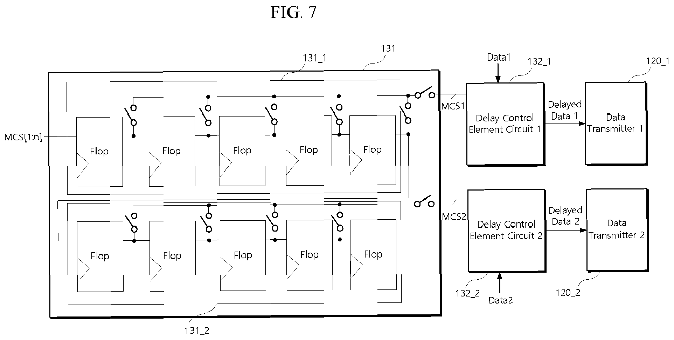

FIG. 7 is a circuit diagram of a delay control input circuit of FIG. 5, according to an embodiment.

FIG. 7 illustrates delay control element circuits 132_1 and 132_2 that delay received data signals Data1 and Data2 by delay control signals MCS1 and MCS2, respectively. Although not shown in FIG. 7, the delay control element circuits 132_1 and 132_2 may delay clock signals received during a time corresponding to the delay control signals MCS1 and MCS2 in the same way.

Referring to FIG. 7, the delay control input circuit 131 according to an embodiment of the present disclosure may receive serialized delay control signals MCS[1:n] and may output the delay control signals MCS1 and MCS2, which are parallelized.

The delay control input circuit 131_1 may include a plurality of flip-flop circuits 131_1 and 131_2. The plurality of flip-flop circuits 131_1 and 131_2 may provide the plurality of parallelized delay control signals MCS1 and MCS2 to the delay control element circuits 132_1 and 132_2, respectively.

For example, some of the delay control signals MCS[1:k-1] among the serialized delay control signals MCS[1:n] having n bits may be parallelized by a delay control element circuit 132_1 and the parallelized delay control signals may be provided to the delay control element circuit 132_1. Some of the delay control signals MCS[k:n] may be paralleled by the delay control element circuit 132_1 and the parallelized delay control signals may be provided to the delay control element circuit 132_2.

The serialized delay control signals MCS[1:n] input to the delay control input circuit 131_1 are sequentially moved or output to each flip-flop of the plurality of flip-flop circuits 131_1 and 131_2 in response to a clock signal. Bits of the delay control signals MCS[1:n] stored in each flip-flop are parallelized and output by turning on switch elements connected to an output terminal of each flip-flop. The delay control signals MCS1 and MCS2 thus parallelized and output are provided to the delay control element circuits 132_1 and 132_2, respectively. The delay control element circuits 132_1 and 132_2 delay data signals Data1 and Data2 received during a time corresponding to the delay control signals MCS1 and MCS2 and provide the delayed data signals to data transmission circuits 120_1 and 120_2, respectively.

Accordingly, the delay control input circuit according to an embodiment of the present disclosure may provide a delay amount to a plurality of delay control element circuits by using a small number of input pins. As a result, the area size occupied by the input pins for inputting the delay control signal MCS of the semiconductor device may be reduced.

Moreover, the delay control input circuit according to an embodiment of the present disclosure may differently input delay control signals input to a plurality of delay control element circuits. In other words, delay amounts of different delay control element circuits may be set differently from each other. Accordingly, the delay amount of each of the plurality of delay control element circuits may be finely adjusted. As a result, even when pieces of skew of a plurality of signals transmitted between a plurality of dies are different from each other, the skews may be finely adjusted.

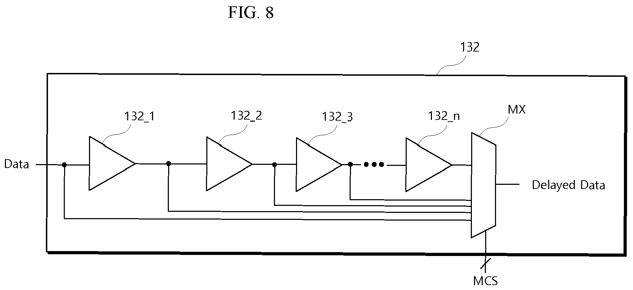

FIG. 8 is a circuit diagram of the delay control element circuit 132 according to an embodiment of FIG. 5.

FIG. 8 illustrates the delay control element circuit 132 that delays the data signal Data received during a time corresponding to the delay control signal MCS. However, the delay control element circuit 132 may delay a clock signal received during a time corresponding to the delay control signal MCS in the same manner.

Referring to FIG. 8, the delay control element circuit 132 according to an embodiment of the present disclosure may delay a data signal by receiving the delay control signal MCS having a plurality of bits.

The delay control element circuit 132 includes a plurality of buffer elements (132_1, 132_2, 132_3, ..., 132_n) and a multiplexer MX.

An output of one buffer element among the plurality of buffer elements (132_1, 132_2, 132_3, ..., 132_n) is provided to an input of another buffer element. In other words, the plurality of buffer elements (132_1, 132_2, 132_3, ..., 132_n) are connected in series to each other. Among the plurality of buffer elements (132_1, 132_2, 132_3, ..., 132_n) connected in series, the buffer element 132_1 at an input terminal receives a signal to be delayed. Each of the plurality of buffer elements (132_1, 132_2, 132_3, ..., 132_n) delays and outputs the input signal during a specific time.

The multiplexer MX receives an output of each of the plurality of buffer elements (132_1, 132_2, 132_3, ..., 132_n). The multiplexer MX selects and outputs one of the plurality of buffer elements (132_1, 132_2, 132_3, ..., 132_n) based on the delay control signal MCS.

The semiconductor device according to an embodiment of the present disclosure may use various types of delay control element circuits in addition to the delay control element circuit described with reference to FIG. 8.

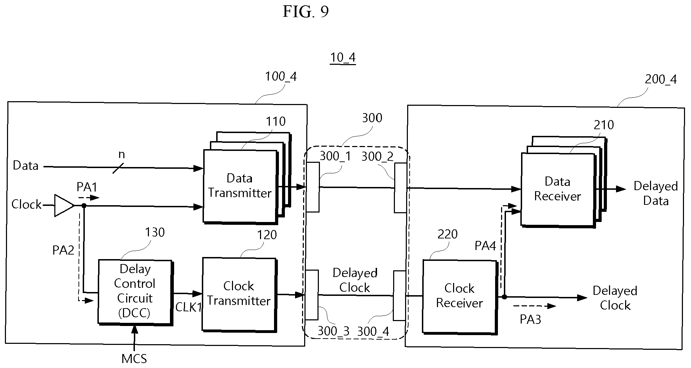

FIG. 9 is a block diagram of a semiconductor device, according to an embodiment of the present disclosure.

Referring to FIG. 9, a semiconductor device 10_4 includes a first die 100_4, a second die 200_4, and the inter-die interface 300. The first die 100_4 may be used to implement the first die 100 and the second die 200_4 may be used to implement the second die 200_4. The first die 100_4 includes the data transmission circuit 110, the clock transmission circuit 120, and the delay control circuit 130. The second die 200_4 includes the data reception circuit 210 and the clock reception circuit 220. Detailed descriptions of parts identical or similar to the above-described parts will be omitted to avoid redundancy.

The delay control circuit 130 of the semiconductor device 10_4 according to an embodiment of the present disclosure is located on a second signal transmission path PA2. The second signal transmission path PA2 refers to a path where the clock signal Clock is input to the clock transmission circuit 120 of the first die 100_4.

The clock signal Clock received from a functional block of the first die 100_4 or an external input may be provided to the first signal transmission path PA1 and the second signal transmission path PA2 through the buffer BF. The clock signal Clock passing through the first signal transmission path PA1 is provided to the data transmission circuit 110. The data transmission circuit 110 provides a data signal to the inter-die interface 300 in response to the received clock signal Clock. The data transmission circuit 110 converts a voltage level of the data signal into a voltage level capable of being transmitted through the inter-die interface 300 and provides the converted signal to the inter-die interface 300. Accordingly, a non-delayed data signal is transmitted to the second die 200_4.

According to an embodiment of the present disclosure, the clock signal Clock passing through the second signal transmission path PA2 is provided to the delay control circuit (DCC) 130. The delay control circuit 130 may delay the received clock signal Clock for a specific time based on the received delay control signal MCS. The delay control circuit 130 provides the clock signal CLK1, which is obtained by delaying the received clock signal Clock for a specific time, to the clock transmission circuit 120. The clock transmission circuit 120 converts a voltage level of the delayed clock signal CLK1 into a voltage level capable of being transmitted through the inter-die interface 300 and provides the converted signal to the inter-die interface 300. Accordingly, the delayed clock signal CLK1 is transmitted to the second die 200_4.

The clock reception circuit 220 of the second die 200_4 receives the delayed clock signal CLK1 and provides the delayed clock signal CLK1 to different clock signal transmission paths PA3 and PA4. The delayed clock signal CLK1 is provided to the data reception circuit 210 through the signal transmission path PA4. The data reception circuit 210 outputs the data signal received from the first die 100_4 based on the delayed clock signal CLK1. As a result, the data reception circuit 210 outputs a delayed data signal Delayed Data.

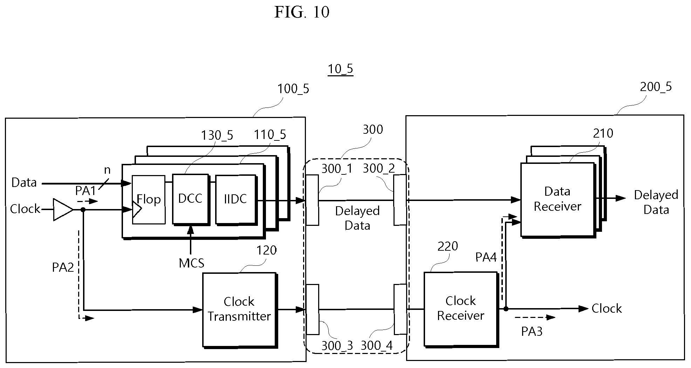

FIG. 10 is a block diagram of a semiconductor device, according to an embodiment of the present disclosure. Referring to FIG. 10, a semiconductor device 10_5 includes a first die 100_5, a second die 200_5, and the inter-die interface 300. The first die 100_5 may be used to implement the first die 100 and the second die 200_5 may be used to implement the second die 200. The first die 100_5 includes a data transmission circuit 110_5, the clock transmission circuit 120, and a delay control circuit 130_5. The second die 200_5 includes the data reception circuit 210 and the clock reception circuit 220. Detailed descriptions of parts identical or similar to the above-described parts will be omitted to avoid redundancy.

The delay control circuit 130_5 of the semiconductor device 10_5 according to an embodiment of the present disclosure is located on a signal transmission path of the data signal Data inside the data transmission circuit 110_5 of the first die 100_5.

The clock signal Clock passing through the first signal transmission path PA1 is provided to the data transmission circuit 110_5. Accordingly, the non-delayed clock signal Clock is provided to the data transmission circuit 110_5.

A clock signal Clock passing through the second signal transmission path PA2 is provided to the clock transmission circuit 120. The clock transmission circuit 120 provides a non-delayed clock signal to the clock reception circuit 220 of the second die 200_5 through the inter-die interface 300.

The data transmission circuit 110_5 according to an embodiment of the present disclosure includes a flip-flop Flop, the delay control circuit 130_5, and an inter-die interface driving circuit IIDC.

The flip-flop Flop provides the delay control circuit 130_5 with the data signal Data received in response to the non-delayed clock signal Clock. The delay control circuit 130_5 delays the received data signal Data for a specific time based on a delay control signal MCS. The delay control circuit 130_5 provides the inter-die interface driving circuit IIDC with a data signal obtained by delaying the received data signal Data during a specific time. The inter-die interface driving circuit IIDC converts the delayed data signal Delayed Data into a voltage level capable of being transmitted through the inter-die interface 300 and transmits the converted signal to the second die 200_5. Accordingly, the second die 200_5 receives the delayed data signal Delayed Data.

The data transmission circuit 110_5 according to an embodiment of the present disclosure may be composed of the plurality of data transmission circuits 110_5. Each of the plurality of data transmission circuits 110_5 may include the delay control circuit 130_5. The delay control signals MCS the same as or different from each other may be provided to the plurality of data transmission circuits 110_5, respectively. Accordingly, when the delay control signals MCS different from each other are respectively provided to the plurality of data transmission circuits 110_5, the plurality of data transmission circuits 110_5 may delay pieces of received data signal during different delay times, respectively.

Accordingly, the degree of delay of each of pieces of data signal may be finely adjusted. As a result, even when pieces of skew of a plurality of data signals transmitted between a plurality of dies are different from each other, the skews may be finely adjusted.

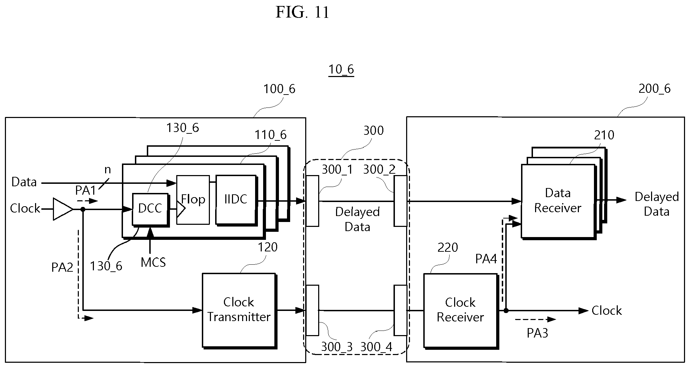

FIG. 11 is a block diagram of a semiconductor device, according to an embodiment of the present disclosure. Referring to FIG. 11, a semiconductor device 10_6 includes a first die 100_6, a second die 200_6, and the inter-die interface 300. The first die 100 may be implemented by the first die 100_6 and the second die 200 may be implemented by the second die 200_6. The first die 100_6 includes a data transmission circuit 110_6, the clock transmission circuit 120, and a delay control circuit 130_6. The second die 200_6 includes the data reception circuit 210 and the clock reception circuit 220. Detailed descriptions of parts identical or similar to the above-described parts will be omitted to avoid redundancy.

The delay control circuit 130_6 of the semiconductor device 10_6 according to an embodiment of the present disclosure is located on a signal transmission path of a clock signal inside the data transmission circuit 110_6 of the first die 100_6.

A clock signal received from a functional block of the first die 100_6 or an external input may be provided to the first signal transmission path PA1 and the second signal transmission path PA2 through the buffer BF.

A clock signal passing through the first signal transmission path PA1 and a clock signal passing through the second signal transmission path PA2 are provided to the data transmission circuit 110_6 and the clock transmission circuit 120, respectively. A non-delayed clock signal is provided to the data transmission circuit 110_6 and the clock transmission circuit 120.

The clock transmission circuit 120 provides the non-delayed clock signal Clock to the clock reception circuit 220 of the second die 200_6 through the inter-die interface 300.

The data transmission circuit 110_6 according to an embodiment of the present disclosure includes the delay control circuit 130_6, the flip-flop Flop, and the inter-die interface driving circuit IIDC.

The delay control circuit 130 delays the received clock signal Clock during a specific time based on the delay control signal MCS. The delay control circuit 130_6 provides the flip-flop Flop with a clock signal, which is obtained by delaying the received clock signal Clock for a specific time.

The flip-flop Flop outputs the data signal Data received based on the delayed clock signal. Accordingly, the delayed data signal is provided to the inter-die interface driving circuit IIDC. The inter-die interface driving circuit IIDC converts the delayed data signal into a voltage level capable of being transmitted through the inter-die interface 300 and transmits the converted signal to the second die 200_6. Accordingly, the second die 200_6 receives the delayed data signal.

The data transmission circuit 110_6 according to an embodiment of the present disclosure may be composed of the plurality of data transmission circuits 110_6. Each of the plurality of data transmission circuits 110_6 may include the delay control circuit 130_6. The delay control signals MCS the same as or different from each other may be provided to the plurality of data transmission circuits 110_6, respectively. Accordingly, when the delay control signals MCS different from each other are respectively provided to the plurality of data transmission circuits 110_6, the plurality of data transmission circuits 110_6 may delay pieces of received data signal during different delay times, respectively.

Accordingly, the degree of delay of each of pieces of data signal may be finely adjusted. As a result, even when pieces of skew of a plurality of data signals transmitted between a plurality of dies are different from each other, the skews may be finely adjusted.

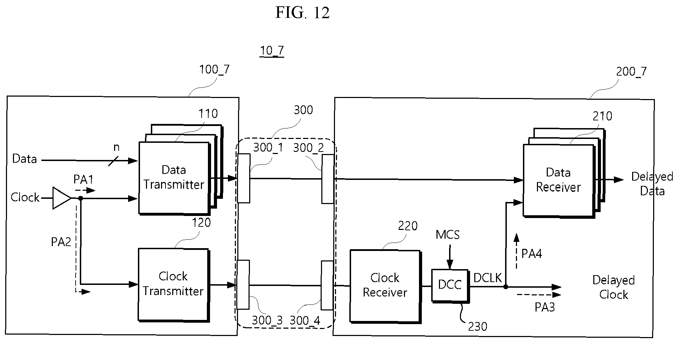

FIG. 12 is a block diagram of a semiconductor device, according to an embodiment of the present disclosure. Referring to FIG. 12, a semiconductor device 10_7 includes a first die 100_7, a second die 200_7, and the inter-die interface 300. The first die 100 may be implemented by the first die 100_7 and the second die 200 may be implemented by the second die 200_7. The first die 100_7 includes the data transmission circuit 110 and the clock transmission circuit 120. The second die 200_7 includes the data reception circuit 210, the clock reception circuit 220, and a delay control circuit 230. Detailed descriptions of parts identical or similar to the above-described parts will be omitted to avoid redundancy.

The delay control circuit 230 according to an embodiment of the present disclosure is located on a signal transmission path that outputs a clock signal received by the clock reception circuit 220 of the second die 200_7.

The first die 100_7 transmits a clock signal and a data signal to the second die 200_7 without delaying the clock signal and the data signal.

The clock reception circuit 220 of the second die 200_7 outputs the clock signal provided by the clock transmission circuit 120 of the first die 100_7 without delaying the clock signal. The clock signal output by the clock reception circuit 220 is provided to the delay control circuit 230.

The delay control circuit 230 according to an embodiment of the present disclosure delays the received clock signal by a specific time. The delay control circuit 230 may delay the received clock signal for the specific time based on the delay control signal MCS to generate a delayed clock signal DCLK. The delay control circuit 230 provide the delayed clock signal DCLK to the data reception circuit 210.

The data reception circuit 210 of the second die 200-7 receives the data signal transmitted by the data transmission circuit 110 of the first die 100_7. The data reception circuit 210 outputs a data signal based on the delayed clock signal DCLK. As a result, the data reception circuit 210 outputs a delayed data signal Delayed Data.

The second die 200_7 according to an embodiment of the present disclosure may include a plurality of data reception circuits 210. The plurality of data reception circuits 210 may be electrically connected to the plurality of inter-die interfaces 300, respectively. Each of the plurality of inter-die interfaces 300 may be composed of a hard macro. For example, each of the plurality of inter-die interfaces 300 may be manufactured by referencing a separate hard macro.

The delayed clock signal DCLK output by the delay control circuit 230 may be provided to each of a plurality of data reception circuits 210. Accordingly, all data signals received by the plurality of data reception circuits 210 may be equally delayed by setting the delay control signal MCS. As a result, skew between a plurality of dies may be reduced.

Besides, as in the above-described embodiments, the delay control circuit may be placed inside the data reception circuit of the second die. In this case, a delayed clock signal or a delayed data signal may be provided to the flip-flop of the data reception circuit.

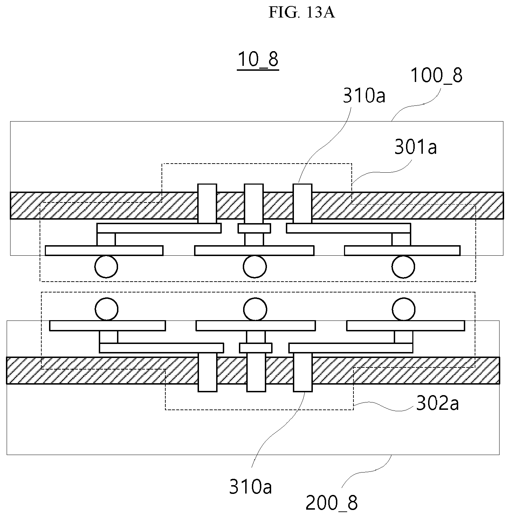

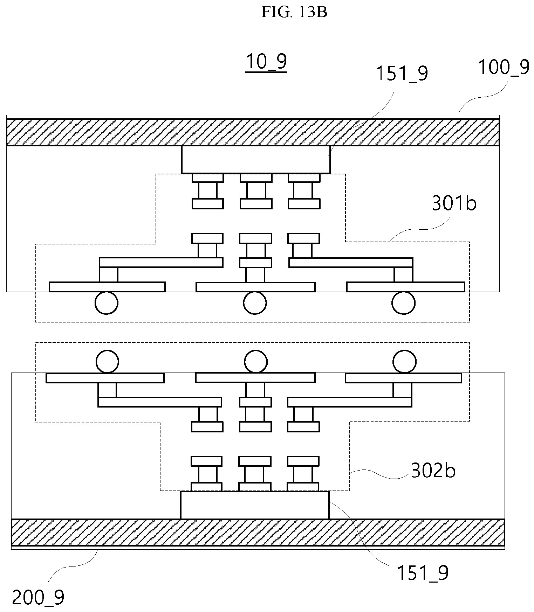

FIGS. 13A and 13B are cross-sectional views showing a semiconductor device, according to an embodiment of the present disclosure. Detailed descriptions of parts identical or similar to the above-described parts will be omitted to avoid redundancy.

Referring to FIG. 13A, both an inter-die interface 301a of a first die 100_8 and an inter-die interface 302a of a second die 200_8 may be formed on back sides of the dies. That is, the first die 100_8 and the second die 200_8 may be coupled to each other through the inter-die interfaces 301a and 302a using back-side to back-side (B2B) bonding.

The inter-die interfaces 301a and 302a of the first die 100_8 and the second die 200_8 may be configured as a hard macro. For example, the inter-die interfaces 301a and 302a of the first die 100_8 and the second die 200_8 may be manufactured using a single hard macro. The inter-die interfaces 301a and 302a of the first die 100_8 and the second die 200_8 may include the TSV 310a.

According to an embodiment, a data transmission/reception circuit or a clock transmission/reception circuit includes the inter-die interfaces 301a and 302a and one hard macro. For example, a data transmission/reception circuit or a clock transmission/reception circuit may include components of the inter-die interfaces 301a and 302a and components referenced by the one hard macro.

According to an embodiment, a delay control circuit, which is placed on a signal transmission path of a clock signal or data signal and which delays a clock signal or data signal may consist of the inter-die interfaces 301a and 302a and one hard macro.

Referring to FIG. 13B, both an inter-die interface 301b of a first die 100_9 and an inter-die interface 302b of a second die 200_9 may be formed on front sides of the dies. That is, the first die 100_9 and the second die 200_9 may be coupled to each other through the inter-die interfaces 301b and 302b using front-side to front-side (F2F) bonding.

The inter-die interfaces 301a and 302b of the first die 100_9 and the second die 200_9 may be configured as a hard macro. For example, components of the inter-die interfaces 301a and 302b of the first die 100_9 and components of the second die 200_9 may be manufactured using a single hard macro. Interface logics 151_9 including a data transmission/reception circuit or a clock transmission/reception circuit may be positioned to be surrounded by a functional block.

According to an embodiment, a data transmission/reception circuit or a clock transmission/reception circuit include the inter-die interfaces 301b and 302b and one hard macro.

According to an embodiment, a delay control circuit, which is placed on a signal transmission path of a clock signal or data signal and which delays the clock signal or data signal includes the inter-die interfaces 301b and 302b and one hard macro.

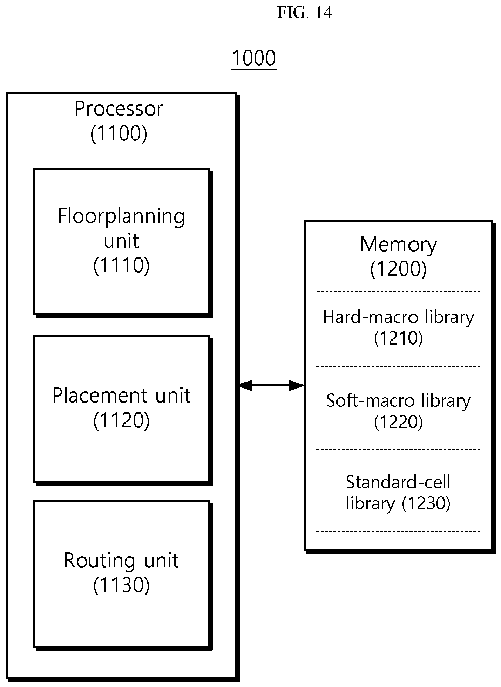

FIG. 14 is a block diagram of a semiconductor designing device, according to an embodiment of the present disclosure.

Referring to FIG. 14, a semiconductor designing device 1000 according to an embodiment may include a processor 1100 and a memory 1200 connected to the processor 1100.

The memory 1200 may be a computer-readable storage medium and may include any storage medium that stores data and/or instructions executed by a computer. For example, the computer-readable storage medium may include a volatile memory such as random-access - memory (RAM) and read-only-memory (ROM), and a non-volatile memory such as flash memory, magneto resistive RAM (MRAM), phase-change RAM (PRAM), and resistive RAM (RRAM). The non-transitory computer-readable storage medium may be capable of being inserted in a computer, may be integrated in the computer, or may be coupled with the computer through a communication medium such as a network and/or a wireless link.

According to an embodiment, the memory 1200 may include a hard-macro library 1210, a soft-macro library 1220, and a standard cell library 1230. At least one of the hard-macro library 1210, the soft-macro library 1220, and the standard cell library 1230 may be provided from the memory 1200 to the processor 1100.

The hard-macro library 1210 may include a plurality of hard-macro cells; the soft-macro library 1220 may include a plurality of soft-macro cells; and, the standard cell library 1230 may include a plurality of standard cells.

The hard-macro cell refers to a building block or functional circuit element of logic incapable of being changed because a wiring pattern is specified and internal routing is completed. The soft-macro cell refers to a building block or functional circuit element of logic that has flexibility in physical implementation in a state where a wiring pattern is not specified, but requires internal routing. The standard cell may be smaller unit than a macro cell, and may be understood as a functional circuit element of logic, a building block, an element, or a unit constituting the minimum unit in the design of a chip. The standard cell may refer to a configuration of a logical element (e.g., an inverter, a flip-flop, or the like) that performs a specific function.

According to an embodiment, the processor 1100 may include a floorplanning unit 1110 (e.g., a first core or first program), a placement unit 1120 (e.g., a second core or second program), and a routing unit 1130 (e.g., a third core or third program). The floorplanning unit 1110 may determine locations where different functional blocks will be placed, sizes and shapes of each block, and how the blocks will be connected with wires to result in an overall floorplan of a circuit to manufacture.

The processor 1100 may place hard-macro cells that define a building block or functional circuit element of logic based on input data defining an integrated circuit and the hard-macro cell library 1210 by using the floorplanning unit 1110. For example, the hard-macro cells of the inter-die network interfaces 301 and 302 of FIG. 3 may be placed.

The processor 1100 may place soft-macro cells and standard cells based on input data defining the integrated circuit, the soft-macro library 1220, and the standard cell library 1230 by using the placement unit 1120.

Moreover, the processor 1100 may perform signal routing on the placement of hard-macro cells, soft-macro cells, and standard cells, which are provided from the floorplanning unit 1110 and the placement unit 1120, by using the routing unit 1130.

For example, when the signal routing is not completed successfully, the floorplanning unit 1110 and the placement unit 1120 may modify the existing layout and then may provide the modified layout. In this case, the wiring layout inside a soft-macro cell may be modified, but the wiring layout inside a hard-macro cell may not be modified. Next, the routing unit 1130 may perform the signal routing on the modified layout again.

In another example, when the signal routing is successfully completed, the routing unit 1130 may generate output data defining the integrated circuit.

According to an embodiment, the floorplanning unit 1110, the placement unit 1120, and the routing unit 1130 may be implemented as one integrated configuration. According to another embodiment, the floorplanning unit 1110, the placement unit 1120, and the routing unit 1130 may be implemented as separate configurations.

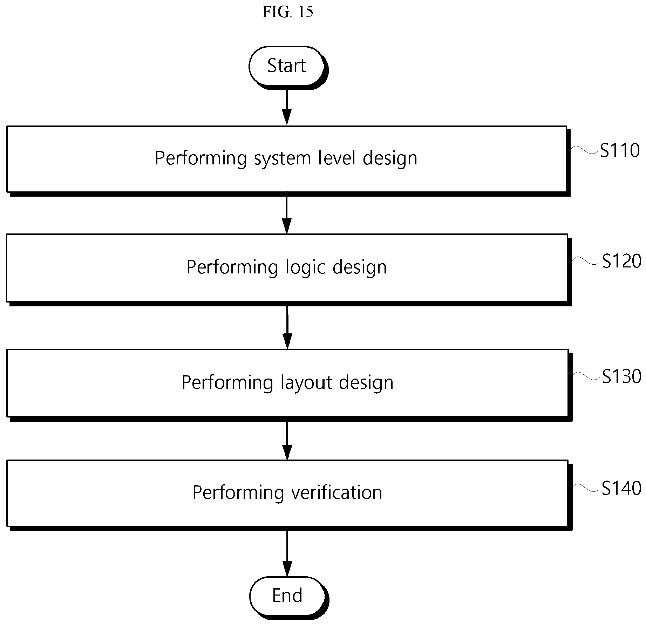

FIG. 15 is a flowchart illustrating an example of an operation of the semiconductor designing device of FIG. 14 according to an embodiment.

Referring to FIGs. 14 and 15, the processor 1100 according to an embodiment may design an integrated circuit by using hard-macro cells, soft-macro cells, and standard cells respectively included in the hard-macro library 1210, the soft-macro library 1220, and the standard cell library 1230. In this case, the processor 1100 may design the integrated circuit by executing a plurality of instructions stored in the memory 1200.

In operation S110, the processor 1100 performs a system level design. The performing of the system level design may include receiving input data defining information about a semiconductor device such as functions, power, timing, and area size of the semiconductor device.

In operation S120, the processor 1100 performs a logic design. The performing of the logic design may include receiving input data defining an integrated circuit and generating a netlist based on the input data.

The processor 1100 may receive the input data from the memory 1200.

The input data may be data defining an integrated circuit including hard-macro cells, soft-macro cells, and standard cells according to an embodiment of the present disclosure. The input data may be data on which a high level design of the integrated circuit is performed by using the semiconductor designing device 1000 of FIG. 14.

For example, the input data may be a bitstream or netlist that is generated by synthesizing an integrated circuit defined by a hardware description language (HDL) such as a VHSIC hardware description language (VHDL) and Verilog.

Moreover, the input data may further include the hard-macro library 1210, the soft-macro library 1220, and the standard cell library 1230 stored in the memory 1200.

In operation S130, the processor 1100 performs a layout design. For example, the processor may generate a layout design of a layout. In an embodiment, the layout design is based on the input data, the hard-macro library 1210, the soft-macro library 1220, and the standard cell library 1230.

In operation, the processor performs a verification on the layout design. The verification may include the processor 1100 identifying at least one of a plurality of hard-macro cells, a plurality of soft-macro cells, and a plurality of standard cells included in the hard-macro library 1210, the soft-macro library 1220, and the standard cell library 1230 for the layout design.

In more detail, the processor 1100 may identify at least one hard-macro cell, which constitutes the integrated circuit defined by the input data, from among the plurality of hard-macro cells included in the hard-macro library 1210.

In this case, the identified hard-macro cell may be referred to as the hard macro of the inter-die network interfaces 301 and 302 of FIG. 3.

In other words, at least one hard-macro cell among hard-macro cells, which are identified by the processor 1100 and on which floorplanning is performed to generate a floorplan, may include an inter-die interface circuit that provides an electrical connection between a plurality of semiconductor dies spaced apart from each other in a vertical direction. The at least one hard-macro cell may include a transmission/reception circuit that transmits and receives a clock signal and a data signal through the inter-die interface circuit. The at least one hard-macro cell may include a delay control circuit. The delay control circuit may be placed on a signal transmission path of a clock signal or data signal and may delay the clock signal or data signal.

According to an embodiment of the present disclosure, the time and load for performing placement and routing of the inter-die interface may be reduced by implementing an inter-die interface by using a hard macro.

Furthermore, even after fab-out of a semiconductor device, the timing may be adjusted to reduce skew between two dies including hard-macro cells of the inter-die interface, for which internal routing is completed, through the delay control circuit.

In this way, the semiconductor designing device 1000 according to an embodiment of the present disclosure may ensure stable operation of an integrated circuit.

According to an embodiment of the present disclosure, an integrated circuit, a semiconductor device, and a semiconductor device layout design method may reduce the skew of transmission signals between stacked dies.

While the present disclosure has been described with reference to embodiments thereof, it will be apparent to those of ordinary skill in the art that various changes and modifications may be made thereto without departing from the scope of the present disclosure as set forth in the following claims.

Embodiments are set out in the following clauses:
Clause 1 A semiconductor device comprising:
   a plurality of semiconductor dies spaced from each other in a vertical direction; and
   an inter-die interface configured to electrically connect the plurality of semiconductor dies,
   wherein the plurality of semiconductor dies includes:
      a transceiver circuit configured to transmit and receive a clock signal and a data signal through the inter-die interface; and
      a delay control circuit located on a signal transmission path of one signal among the clock signal and the data signal to delay the one signal,
      wherein at least one semiconductor die among the plurality of semiconductor dies is a logic die.
Clause 2 The semiconductor device of clause 1, wherein at least one semiconductor die among the plurality of semiconductor dies includes at least one functional block, and at least one of the transceiver circuit and the delay control circuit is located inside the functional block.
Clause 3 The semiconductor device of clause 2, wherein the inter-die interface includes:
   a plurality of interface contacts electrically connected to the transceiver circuit; and
   a plurality of inter-die contacts electrically connected to the plurality of interface contacts respectively and configured to physically couple the plurality of semiconductor dies to each other, and
   wherein a pitch between the plurality of inter-die contacts is greater than a pitch between the plurality of interface contacts.
Clause 4 The semiconductor device of any preceding clause, wherein a single hard macro represents at least part of the inter-die interface and the transceiver circuit.
Clause 5 The semiconductor device of clause 4, wherein the hard macro further represents the delay control circuit.
Clause 6 The semiconductor device of clause 4 or 5, wherein the hard macro includes a plurality of inter-die contacts, which provide an electrical connection between the plurality of semiconductor dies and physically couple the plurality of semiconductor dies.
Clause 7 The semiconductor device of clause 6, wherein the hard macro includes a signal transmission path between the transceiver circuit and one of the plurality of inter-die contacts.
Clause 8 The semiconductor device of any preceding clause, wherein the inter-die interface of at least one semiconductor die among the plurality of semiconductor dies includes:
   a plurality of micro-bumps, each of which provides an electrical connection or contact between the plurality of semiconductor dies; and
   a through-silicon-via (TSV) electrically connected to one of the plurality of micro-bumps and configured to exchange the clock signal and the data signal between the plurality of semiconductor dies.
Clause 9 The semiconductor device of any preceding clause, wherein the delay control circuit delays the clock signal provided to a flip-flop of the transceiver circuit to generate a delayed clock signal.
Clause 10 The semiconductor device of clause 9, wherein each of the plurality of semiconductor dies includes:
   the inter-die interface including a plurality of inter-die interfaces; and
   a plurality of transceiver circuits respectively connected to the plurality of inter-die interfaces, and
   wherein the delay control circuit is included in each of the plurality of transceiver circuits.
Clause 11 The semiconductor device of clause 9, wherein the plurality of semiconductor dies includes a first die and a second die,
   wherein each of the first die and the second die includes:
   the inter-die interface including a plurality of inter-die interfaces; and
   a plurality of transceiver circuits respectively connected to the plurality of inter-die interfaces, and
   wherein the delay control circuit of the first die provides the delayed clock signal to the plurality of transceiver circuits of the first die or the plurality of transceiver circuits of the second die.
Clause 12 The semiconductor device of any of clauses 1 to 9, wherein the transceiver circuit includes a signal output circuit and a driving circuit.
Clause 13 The semiconductor device of clause 12, wherein the delay control circuit is located on a data signal transmission path inside the transceiver circuit and delays the data signal.
Clause 14 The semiconductor device of any of clauses 1 to 8, wherein the delay control circuit comprises:
   a delay control input circuit configured to receive a delay control signal, which is serialized, for controlling a plurality of delay elements and to parallelize and output the delay control signal; and
   a delay control element circuit including the plurality of delay elements.
Clause 15 A method of designing a layout of a semiconductor device, the method comprising:
   identifying at least one hard macro among a plurality of hard macros and at least one standard cell based on input data defining an integrated circuit;
   performing floorplanning on the identified at least one hard macro based on the input data;
   performing placing of the identified at least one standard cell based on a result of the floorplanning;
   performing routing based on a result of the floorplanning and a result of the placing; and
   generating output data defining the integrated circuit based on the results of the floorplanning, the placing, and the routing,
   wherein the at least one hard macro includes:
      a design for an inter-die interface circuit configured to provide an electrical connection between a plurality of semiconductor dies spaced apart from each other in a vertical direction;
      a design for a transceiver circuit configured to transmit and receive a clock signal and a data signal through the inter-die interface circuit; and
      a design for a delay control circuit located on a signal transmission path of one signal among the clock signal and the data signal and configured to delay the one signal.

## Claims

1. A semiconductor device comprising:
a plurality of semiconductor dies spaced from each other in a vertical direction; and
an inter-die interface configured to electrically connect the plurality of semiconductor dies,
wherein the plurality of semiconductor dies includes:
a transceiver circuit configured to transmit and receive a clock signal and a data signal through the inter-die interface; and
a delay control circuit located on a signal transmission path of one signal among the clock signal and the data signal to delay the one signal,
wherein at least one semiconductor die among the plurality of semiconductor dies is a logic die.

2. The semiconductor device of claim 1, wherein at least one semiconductor die among the plurality of semiconductor dies includes at least one functional block, and at least one of the transceiver circuit and the delay control circuit is located inside the functional block.

3. The semiconductor device of claim 2, wherein the inter-die interface includes:
a plurality of interface contacts electrically connected to the transceiver circuit; and
a plurality of inter-die contacts electrically connected to the plurality of interface contacts respectively and configured to physically couple the plurality of semiconductor dies to each other, and
wherein a pitch between the plurality of inter-die contacts is greater than a pitch between the plurality of interface contacts.

4. The semiconductor device of any preceding claim, wherein a single hard macro represents at least part of the inter-die interface and the transceiver circuit.

5. The semiconductor device of claim 4, wherein the hard macro further represents the delay control circuit.

6. The semiconductor device of claim 4 or 5, wherein the hard macro includes a plurality of inter-die contacts, which provide an electrical connection between the plurality of semiconductor dies and physically couple the plurality of semiconductor dies.

7. The semiconductor device of claim 6, wherein the hard macro includes a signal transmission path between the transceiver circuit and one of the plurality of inter-die contacts.

8. The semiconductor device of any preceding claim, wherein the inter-die interface of at least one semiconductor die among the plurality of semiconductor dies includes:
a plurality of micro-bumps, each of which provides an electrical connection or contact between the plurality of semiconductor dies; and
a through-silicon-via (TSV) electrically connected to one of the plurality of micro-bumps and configured to exchange the clock signal and the data signal between the plurality of semiconductor dies.

9. The semiconductor device of any preceding claim, wherein the delay control circuit delays the clock signal provided to a flip-flop of the transceiver circuit to generate a delayed data signal.

10. The semiconductor device of claim 9, wherein each of the plurality of semiconductor dies includes:
the inter-die interface including a plurality of inter-die interfaces; and
a plurality of transceiver circuits respectively connected to the plurality of inter-die interfaces, and
wherein the delay control circuit is included in each of the plurality of transceiver circuits.

11. The semiconductor device of claim 9, wherein the plurality of semiconductor dies includes a first die and a second die,
wherein each of the first die and the second die includes:
the inter-die interface including a plurality of inter-die interfaces; and
a plurality of transceiver circuits respectively connected to the plurality of inter-die interfaces, and
wherein the delay control circuit of the first die provides the delayed clock signal to the plurality of transceiver circuits of the first die or the plurality of transceiver circuits of the second die.

12. The semiconductor device of any of claims 1 to 9, wherein the transceiver circuit includes a signal output circuit and a driving circuit.

13. The semiconductor device of claim 12, wherein the delay control circuit is located on a data signal transmission path inside the transceiver circuit and delays the data signal.

14. The semiconductor device of any of claims 1 to 8, wherein the delay control circuit comprises:
a delay control input circuit configured to receive a delay control signal, which is serialized, for controlling a plurality of delay elements and to parallelize and output the delay control signal; and
a delay control element circuit including the plurality of delay elements.

15. A method of designing a layout of a semiconductor device, the method comprising:
identifying at least one hard macro among a plurality of hard macros and at least one standard cell based on input data defining an integrated circuit;
performing floorplanning on the identified at least one hard macro based on the input data;
performing placing of the identified at least one standard cell based on a result of the floorplanning;
performing routing based on a result of the floorplanning and a result of the placing; and
generating output data defining the integrated circuit based on the results of the floorplanning, the placing, and the routing,
wherein the at least one hard macro includes:
a design for an inter-die interface circuit configured to provide an electrical connection between a plurality of semiconductor dies spaced apart from each other in a vertical direction;
a design for a transceiver circuit configured to transmit and receive a clock signal and a data signal through the inter-die interface circuit; and
a design for a delay control circuit located on a signal transmission path of one signal among the clock signal and the data signal and configured to delay the one signal.
